# EUROPEAN PATENT SPECIFICATION

(11) **EP 2 888 389 B1**
(45) Date of publication and mention of the grant of the patent: **30.12.2020**
(21) Application number: 13798727.7
(22) Date of filing: 08.11.2013
(51) Int. Cl.: C09D 183/08, C23C 18/18, C23C 18/16, C23C 18/54

(54) **PRETREATMENT METHOD FOR PARTIAL PLATING, PARTIAL PLATING METHOD FOR ALUMINUM MATERIALS, AND CORRESPONDING SUBSTRATE WITH RESIST**
VORBEHANDLUNGSVERFAHREN ZUR PARTIELLEN BESCHICHTUNG, VERFAHREN ZUR PARTIELLEN BESCHICHTUNG VON ALUMINIUMMATERIALIEN UND ENTSPRECHENDES SUBSTRAT MIT RESIST
MÉTHODE DE PRÉTRAITEMENT POUR LE PLACAGE PARTIEL, MÉTHODE DE PLACAGE PARTIEL POUR LES MATÉRIAUX EN ALUMINIUM, ET SUBSTRAT CORRESPONDANT AVEC RÉSIST

(30) Priority: 12.11.2012 JP 2012248723
(43) Date of publication of application: 01.07.2015
(73) Proprietor: TOYOTA JIDOSHA KABUSHIKI KAISHA, Toyota-shi, Aichi-ken, 471-8571 (JP); National University Corporation Nagoya University, Aichi-ken 464-8601 (JP)
(72) Inventor: BESSHO, Takeshi, Toyota-shi, Aichi-ken, 471-8571 (JP); SAITO, Nagahiro, Nagoya-shi Aichi-ken 464-8601 (JP); TAKAI, Osamu, 1-1-1 Fukuura, Kanazawa-ku, Yokohama 236-0004 (JP); TAKATA, Satoshi, Toyota Aichi 470-0334 (JP)
(74) Representative: Kuhnen & Wacker Patent- und Rechtsanwaltsbüro PartG mbB
(86) International application number: PCT/IB2013/002490
(87) International publication number: WO 2014/072800

(56) References cited:
- EP-A1- 1 426 464
- JP-A- 2000 282 240
- JP-A- 2006 057 167
- US-A1- 2005 042 430
- Gelest Inc.: "Hydrophobicity, Hydrophilicity and Silane Surface Modification", , 24 May 2011 (2011-05-24), pages 1-82, XP055098863, Retrieved from the Internet: URL:https://acs.expoplanner.com/files/acsf all13/ExhibFiles/1047_1100_HydrophobicityC atalogUS_5-24-11.pdf [retrieved on 2014-01-28]
- FURUKAWA Y ET AL: "FLUOROSILICONE ELASTOMER BASED ON THE POLYÄ3,3,3-TRIFLUOROPROPYL)METHYL-SILOXANE -CO-(3,3,4,4,5,5,6,6,6-NONAFLUOROHEXYL)MET HYLSILOXANEÜ", POLYMERS FOR ADVANCED TECHNOLOGIES, WILEY & SONS, BOGNOR REGIS, GB, vol. 13, no. 1, 1 January 2002 (2002-01-01), pages 60-65, XP001112071, ISSN: 1042-7147, DOI: 10.1002/PAT.155

## Description

### BACKGROUND OF THE INVENTION

### 1. Field of the Invention

The invention relates to a pretreatment method for partial plating, a method for the partial plating of aluminum materials, and a substrate constituted by an aluminum material comprising a resist for plating said substrate.

### 2. Description of Related Art

Aluminum materials have a high specific strength, and their applications are growing more widespread with the goal of improving the fuel economy in transport vehicles, e.g., automobiles, through weight reduction. The corrosion resistance and wear resistance can be improved and a high hardness can be generated when a nickel plating is executed on aluminum materials. On the other hand, aluminum materials readily form oxidation films under the effect of atmospheric oxygen. As a consequence, aluminum materials are classified as hard-to-plate materials that exhibit a poor adherence between the plating film and the material. A double zincate treatment is therefore generally performed as a pretreatment during the plating treatment of an aluminum material in order to ensure the adherence of the plating film. In a double zincate treatment, the substrate is immersed in a zinc conversion treatment bath. The zinc film deposited due to the immersion is stripped using nitric acid, followed by another immersion in a zinc treatment bath. The zinc conversion treatment bath is generally a strongly alkaline solution that contains sodium hydroxide.

The use of a partial plating method - in which a plating film is formed only on the required part - in the plating treatment of a material can be expected to provide reduced costs and to lower the environmental load by extending the life of the plating bath. An organic thick film, e.g., masking tape or a photosensitive film, has conventionally been used for the plating resist used in partial plating methods. A resist removal treatment is required when such an organic thick film is used, but the environmental load imposed by the etching bath and the balance between the resistance of the film to the plating chemicals and the ease of resist removal have been problems. With the goal of lowering the environmental load, the inventors investigated the use of a self-assembled monolayer (SAM) as a plating resist. For example, Japanese Patent Application Publication No. 2006-57167 (JP 2006-57167 A) provides an example of the use of a SAM in a method for carrying out partial plating in a desired pattern on a substrate.

JP 2006-57167 A discloses an example that uses heptadecafluoro-1,1,2,2-tetrahydrodecyl-1-trimethoxysilane : F₃C(CF₂)₇(CH₂)₂Si(OCH₃)₃ (referred to as "FAS" herein) as the molecule that forms the SAM. It was thought that the SAM formed from this FAS could be used as a plating resist because it is less prone to adsorb the plating catalyst than the surface of the substrate and because it can be removed by photoexposure. JP 2006-57167 A discloses an example in which FAS is used to form copper wiring on a substrate whose surface is provided with a silicon oxide film.

However, it was found that when the FAS monolayer described in JP 2006-57167 A is formed into a film as a resist in the plating treatment of aluminum materials, the substrate is not completely coated by this monolayer and, when immersion in a zinc conversion treatment bath is carried out, zinc ends up being deposited on the substrate even in regions where a resist film has been formed. It was also found that the resist is peeled off by the strong alkali. As a consequence, the use of the FAS described in JP 2006-57167 A as a resist for partial plating is disadvantageous with respect to the plating of aluminum materials where a double zincate treatment is required. Since partial plating methods that use a SAM as a resist are useful, the discovery of a starting material of a SAM that could be used as a resist even in the plating treatment of aluminum materials was desired.
Generic plating methods are known from document EP 1 426 464 A1.

### SUMMARY OF THE INVENTION

As a result of investigations into the problem described above, the inventors discovered that the combination of two specific fluoroalkylsilanes is particularly well suited for forming a SAM that functions as a resist in the plating treatment of aluminum materials. The invention provides a pretreatment method for partial plating, a partial plating method for aluminum materials, and a substrate constituted by an aluminum material comprising a resist for plating said substrate. The problem identified above is solved by the subject-matter of the independent claims.

A first aspect of the invention is a pretreatment method for partial plating. The pretreatment method includes the following: forming, as a resist, on a substrate constituted by an aluminum material, a SAM from a mixture of nonafluorohexyltrimethoxysilane and trifluoropropyltrimethoxysilane; and subjecting the substrate to a zincate treatment.

The mixing ratio between the nonafluorohexyltrimethoxysilane and the trifluoropropyltrimethoxysilane in the first aspect of the invention is 4 : 6 to 6 : 4. The zincate treatment in the first aspect of the invention may be a double zincate treatment. The first aspect of the invention also includes removing a portion of the self-assembled monolayer from the substrate by exposure to light prior to the zincate treatment, the portion of the self-assembled monolayer corresponding to a portion of the substrate to be plated.

A second aspect of the invention is a method for the partial plating of an aluminum material. The method includes the following: carrying out, on a substrate constituted by the aluminum material, a pretreatment of partial plating by the method according to claim 1 or 2 of the invention; and executing a plating treatment on the substrate.

The plating may be a nickel plating in the second aspect of the invention.

A third aspect of the invention is a substrate constituted by an aluminum material comprising a resist for plating an aluminum material according to claim 5. The resist contains nonafluorohexyltrimethoxysilane and trifluoropropyltrimethoxysilane.

The mixing ratio between the nonafluorohexyltrimethoxysilane and the trifluoropropyltrimethoxysilane is 4 : 6 to 6 : 4 in the third aspect of the invention.

A SAM formed using a mixture of nonafluorohexyltrimethoxysilane and trifluoropropyltrimethoxysilane can almost completely coat a substrate constituted of an aluminum material and also has a high resistance to acid and alkali. As a consequence, it can prevent the deposition of zinc without exfoliating even during a zincate treatment. The aspects of the invention can thus provide an excellent method for the partial plating of aluminum materials, an excellent pretreatment method and an excellent resist for the same.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a schematic diagram of the cross-sectional structure of a SAM formed using a mixture of FAS9 and FAS3;
FIG. 2 is a graph that shows the relationships between the FAS3-to-FAS9 molar mixing ratio and the plating deposition weight ratio and the water contact angle of the SAM;
FIG. 3 is the X-ray Photoelectron Spectroscopy (XPS) spectrum obtained from SAMs formed using, respectively, FAS9 only, FAS3 only, and a mixed fluid of FAS9 and FAS3; and
FIG. 4 is a graph that shows the relationship between the time of exposure to vacuum ultraviolet light (VUV) and the water contact angle of SAMs.

### DETAILED DESCRIPTION OF EMBODIMENTS

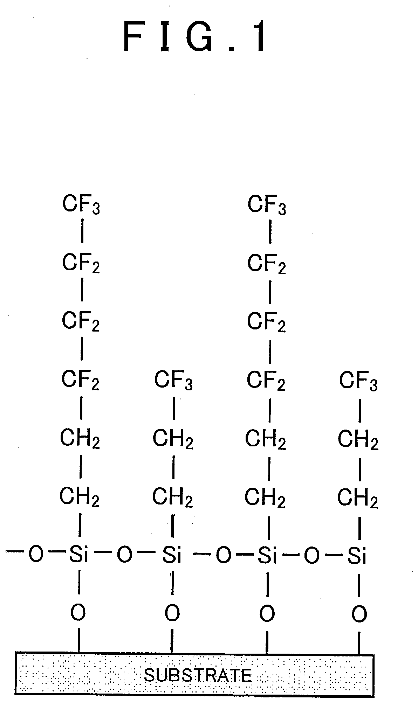

The method according to an embodiment of the invention relates to a method for the partial plating of an aluminum material constituted by aluminum or an aluminum alloy, and uses a mixture of nonafluorohexyltrimethoxysilane (CF₃(CF₂)₃(CH₂)₂-Si(OCH₃)₃: also referred to as FAS9) and trifluoropropyltrimethoxysilane (CF₃(CH₂)₂-Si(OCH₃)₃: also referred to as FAS3) as a resist. That is, a SAM is formed from a mixture of FAS9 and FAS3. A schematic drawing of the cross-sectional structure of the SAM formed using this FAS9 and FAS3 mixture is shown in FIG. 1.

The SAM formed using an FAS9 and FAS3 mixture has a higher resistance to acid and alkali than a SAM formed of each of these substances individually and in addition can almost completely coat the substrate constituted by an aluminum material. In addition, the substrate is coated with CF₃ group having a low surface energy when such a SAM is formed and the water repellency is thus increased. As a consequence, the SAM used as a resist repels the zinc conversion treatment bath and so on. Thus, when this SAM is used as a resist, the potential for resist exfoliation and the potential for zinc deposition in regions where a resist film has been formed are reduced - even when the substrate is subjected to a zincate treatment and in particular is subjected to a double zincate treatment.

The mixing ratio in the FAS9 and FAS3 mixture is in the range from 4 : 6 to 6 : 4, preferably in the range from 4.5 : 5.5 to 5.5 : 4.5, and particularly preferably is 5 : 5. The SAM exhibits a particularly high functionality as a resist when these mixing ratios are used. Film formation of the SAM may be carried out using a chemical vapor deposition (CVD) method, a plasma CVD method, a physical vapor deposition (PVD) method, and so forth, but film formation by a vapor-phase method such as a CVD method is preferred because this yields a small amount of liquid waste.

The method of the embodiment of the invention includes the execution of a zincate treatment on the substrate after the formation, using a mixture of FAS9 and FAS3, of the SAM as a resist on the substrate constituted by the aluminum material. The zincate treatment includes immersion of the substrate in a zinc conversion treatment bath. The zincate treatment is preferably a double zincate treatment. The double zincate treatment includes a first immersion of the substrate in a zinc conversion treatment bath, followed by immersion of the substrate in, for example, nitric acid, to strip off the deposited zinc and then re-immersion of the substrate in a zinc conversion treatment bath. Zincate treatments are available to the individual skilled in the art, and a commercially available zinc conversion treatment bath may be used. The SAM used as a resist in the method of the embodiment of the invention and formed using a mixture of FAS9 and FAS3 is resistant to both the strongly alkaline zinc conversion treatment bath and the strongly acidic zinc stripper. As a consequence, the resist of the embodiment of the invention is more resistant to exfoliation than the related art - even when a double zincate treatment is carried out.

The SAM formed using the FAS9 and FAS3 mixture can be removed, without using an etching bath, by inducing oxidative decomposition by exposure to light. The method of the embodiment of the invention as necessary includes a step of a removal of the SAM by photoexposure prior to the zincate treatment. The light source used for this photoexposure is preferably ultraviolet light or VUV light. The photoexposure is preferably carried out, for example, in the atmosphere at a wavelength of 172 nm and an intensity of 10 mW/cm² for 5 to 15 minutes, particularly 8 to 12 minutes, and more particularly approximately 10 minutes. After the SAM has been exposed to light, the substrate may be washed as necessary. A plating film is formed, by the zincate treatment and plating treatments subsequent thereto, on the portion of the substrate from which the SAM has been removed by the photoexposure.

The SAM using the FAS9 and FAS3 mixture of the invention is particularly well suited for use as a resist in particular for carrying out the partial plating of nickel onto a substrate constituted by an aluminum material. The plating is preferably carried out using electroless plating. Procedures for electroless nickel plating are available to the individual skilled in the art, and this may be carried out by immersing the substrate in any commercially available plating bath.

The invention is more particularly described in the following using examples, but the invention is not limited to or by these examples.

A plating treatment procedure is described in the following. A high-purity aluminum plate was used as the substrate in the film formation step. The substrate was cleaned ultrasonically and then exposed to VUV in order to hydroxylate the surface and was thereafter used for testing. The substrate and the starting material for the SAM were sealed in an airtight container of Teflon (registered trademark) and were heated for 3 hours at 200°C to form a SAM on the substrate. After this, the substrate on which the SAM was formed was removed and cleaned ultrasonically. The following were used as SAM starting materials: mixtures of FAS9 and FAS3, FAS13 by itself, FAS9 by itself, and FAS3 by itself. The compound name and rational formula of the individual starting materials are given below.
FAS9: nonafluorohexyltrimethoxysilane (CF₃(CF₂)₃(CH₂)₂-Si(OCH₃)₃)
FAS3: trifluoropropyltrimethoxysilane (CF₃(CH₂)₂-Si(OCH₃)₃)
FAS13: tridecafluorooctyltrimethoxysilane (CF₃(CF₂)₅(CH₂)₂Si(OCH₃)₃)

In the photoexposure step, the SAM-bearing substrate was exposed to VUV light in order to remove the SAM in those regions where the deposition of plating was desired.

In the zinc conversion step (double zincate treatment), the substrate was immersed in the first zinc conversion treatment in a 200 mL/L aqueous solution (pH ≅ 14) of Alumon EN (Meltex Incorporated). The substrate was then immersed in a 34% aqueous nitric acid solution to perform a zinc stripping treatment, and the substrate was thereafter immersed again in a 200 mL/L aqueous solution (pH ≅ 14) of Alumon EN for the second zinc conversion treatment.

For the plating step, an electroless nickel plating treatment was carried out by immersing the substrate in Melplate NI-4990 (Meltex Incorporated, 82°C, pH = 7). The plating thickness was 5 µm.

The evaluation of the plating treatment is described in the following. The plating deposition inhibiting effect of the SAM is described first. The plating deposition weight ratio was determined for the plating deposition weight provided by carrying out the plating treatment according to the above-described procedure (excluding the photoexposure step), with reference to the plating deposition weight when the SAM was not formed. The water contact angle of the SAM after the plating treatment was also measured.

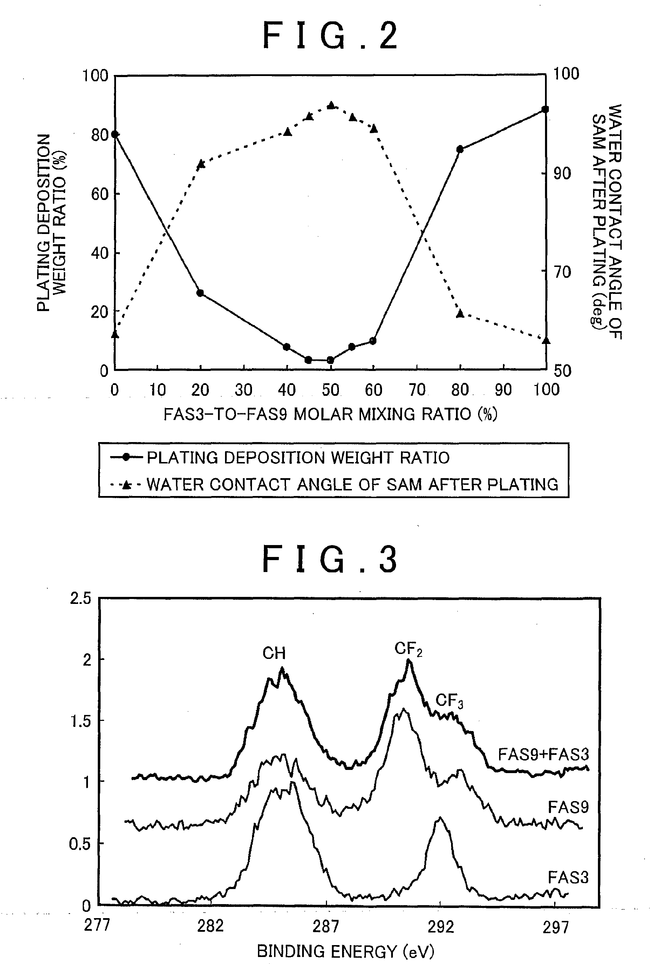

FIG. 2 is a graph that shows the relationships between the FAS3-to-FAS9 molar mixing ratio and the plating deposition weight ratio and the water contact angle of the SAM. A low plating deposition weight ratio means that plating deposition was inhibited by the SAM. In addition, a large water contact angle after the plating treatment means that the SAM remained even after plating and that in the zinc conversion step the SAM repelled the zinc solution and prevented zinc deposition.

An inhibition of plating deposition was almost completely absent when the molar mixing ratio was 0% (FAS9 only) and 100% (FAS3 only). The same result was also obtained for the use of FAS13 by itself. This is thought to have occurred because the SAM composed of only FAS9, or only FAS3, or only FAS13 underwent, for example, exfoliation during the zinc conversion step. A plating deposition inhibitory effect was observed for the FAS9 and FAS3 mixture, and a trend was observed wherein the plating inhibitory effect reached a maximum for a molar mixing ratio of 40 to 60% and particularly of around 50%.

The evaluation of the SAM surface composition is now described. The XPS spectrum was measured on the surface of the SAM formed on the substrate using the procedure in the film formation step in the plating treatment described above. FIG. 3 shows the spectra obtained for the individual SAMs formed using FAS9 alone, FAS3 alone, and a mixed fluid of FAS9 and FAS3 (FAS3-to-FAS9 molar mixing ratio = 50%). The spectrum obtained using the FAS9 + FAS3 mixed fluid had a shape that was the sum of the spectra obtained using each alone. It is therefore thought that a SAM having a structure in which the FAS9 is mixed with the FAS3 is obtained when the FAS9 + FAS3 mixed fluid is used.

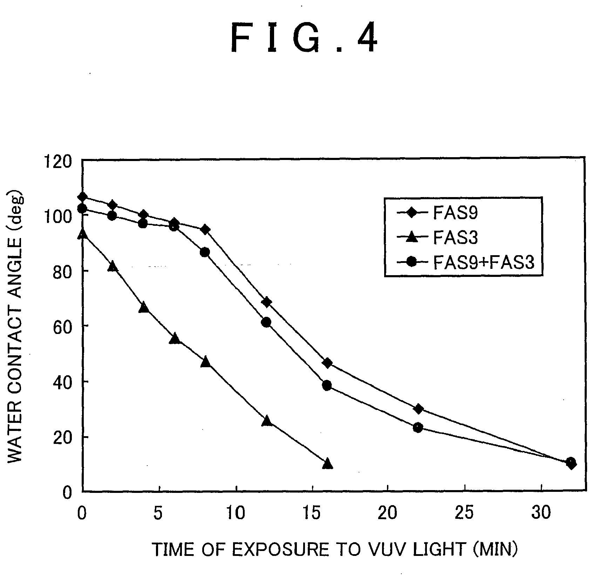

The removal behavior of the SAM is considered now. The water contact angle after VUV exposure was measured in order to check the ease of removal by exposure of the formed SAM to VUV light. FIG. 4 is a graph that shows the relationship between the exposure time and the water contact angle. The SAM formed using the mixed fluid of FAS9 and FAS3 (FAS3-to-FAS9 molar mixing ratio = 50%) was found to exhibit a water contact angle in between the values obtained for the SAMs formed using FAS9 alone and using FAS3 alone, and thus was found to have an ease of removal in between each of these used by itself. Accordingly, an FAS9 + FAS3 mixed SAM is thought to be removable by VUV-induced oxidative decomposition and to be usable as a photoremovable plating resist.

## Claims

1. A pretreatment method for partial plating, comprising:
preparing a mixture of nonafluorohexyltrimethoxysilane and trifluoropropyltrimethoxysilane as a self-assembled monolayer starting material;
forming, as a resist, on a substrate constituted by an aluminum material, a self-assembled monolayer from the mixture of nonafluorohexyltrimethoxysilane and trifluoropropyltrimethoxysilane; and
subjecting the substrate to a zincate treatment, wherein a molar mixing ratio between the nonafluorohexyltrimethoxysilane and the trifluoropropyltrimethoxysilane is 4 : 6 to 6 : 4;
wherein the pretreatment method further comprises the step of:
removing a portion of the self-assembled monolayer from the substrate by exposure to light prior to the zincate treatment, the portion of the self-assembled monolayer corresponding to a portion of the substrate to be plated.

2. The pretreatment method according to claim 1, wherein the zincate treatment is a double zincate treatment.

3. A method for partial plating an aluminum material, **characterized by** comprising:
carrying out, on a substrate constituted by the aluminum material, a pretreatment of partial plating by the method according to claim 1 or 2; and
executing a plating treatment on the substrate.

4. The method for partial plating according to claim 3, wherein a plating formed by executing the plating treatment is a nickel plating.

5. A substrate constituted by an aluminum material, the substrate comprising a resist for plating said substrate, the resist comprising a self-assembled monolayer formed on the substrate from a mixture of nonafluorohexyltrimethoxysilane and trifluoropropyltrimethoxysilane, wherein a molar mixing ratio between the nonafluorohexyltrimethoxysilane and the trifluoropropyltrimethoxysilane is 4 : 6 to 6 : 4.

## Patentansprüche

1. Vorbehandlungsverfahren für eine Teilbeschichtung, aufweisend:
Bereiten einer Mischung aus Nonafluorohexyltrimethoxysilan und Trifluoropropyltrimethoxysilan als Startmaterial selbst organisierender Monoschichten;
Bilden, als ein Abdeckmittel, auf einem Substrat, das aus einem Aluminiummaterial besteht, einer selbst organisierenden Monoschicht aus der Mischung aus Nonafluorohexyltrimethoxysilan und Trifluoropropyltrimethoxysilan; und
Unterziehen des Substrats einer Zinkatbehandung, wobei ein molares Mischverhältnis zwischen dem Nonafluorohexyltrimethoxysilan und dem Trifluoropropyltrimethoxysilan 4:6 bis 6:4 beträgt;
wobei das Vorbehandlungsverfahren ferner den folgenden Schritt aufweist:
Entfernen eines Abschnitts der selbst organisierenden Monoschicht von dem Substrat durch Lichteinwirkung vor der Zinkatbehandlung, wobei der Abschnitt der selbst organisierenden Monoschicht einem Abschnitt des zu beschichtenden Substrats entspricht.

2. Vorbehandlungsverfahren nach Anspruch 1, wobei die Zinkatbehandlung eine Doppelzinkatbehandlung ist.

3. Verfahren zur Teilbeschichtung eines Aluminiummaterials, **dadurch gekennzeichnet, dass** es aufweist:
Durchführen, auf einem Substrat, das aus dem Aluminiummaterial besteht, einer Vorbehandlung des Teilbeschichtens durch das Verfahren nach Anspruch 1 oder 2; und
Ausführen einer Beschichtungsbehandlung auf dem Substrat.

4. Verfahren zur Teilbeschichtung nach Anspruch 3, wobei eine Beschichtung, die durch Ausführen der Beschichtungsbehandlung gebildet wird, eine Nickelbeschichtung ist.

5. Substrat, das aus einem Aluminiummaterial besteht, wobei das Substrat ein Abdeckmittel zum Beschichten des Substrats aufweist, wobei das Abdeckmittel eine selbst organisierende Monoschicht aufweist, die auf dem Substrat aus einer Mischung aus Nonafluorohexyltrimethoxysilan und Trifluoropropyltrimethoxysilan gebildet ist, wobei ein molares Mischverhältnis zwischen dem Nonafluorohexyltrimethoxysilan und dem Trifluoropropyltrimethoxysilan 4:6 bis 6:4 beträgt.

## Revendications

1. Procédé de prétraitement pour placage partiel, comprenant le fait de :
préparer un mélange de nonafluorohexyltriméthoxysilane et de trifluoropropyltriméthoxysilane comme produit de départ monocouche auto-assemblé ;
former, en tant que réserve, sur un substrat constitué par une matière en aluminium, une monocouche auto-assemblée du mélange à partir du nonafluorohexyltriméthoxysilane et du trifluoropropyltriméthoxysilane ; et
soumettre le substrat à un traitement de zincate, un rapport de mélange molaire entre le nonafluorohexyltriméthoxysilane et le trifluoropropyltriméthoxysilane étant de 4 : 6 à 6 : 4 ;
le procédé de prétraitement comprenant en outre l'étape de :
retrait d'une partie de la monocouche auto-assemblée du substrat par exposition à de la lumière avant le traitement de zincate, la partie de la monocouche auto-assemblée correspondant à une partie du substrat devant être plaqué.

2. Procédé de prétraitement selon la revendication 1, selon lequel le traitement de zincate est un double traitement de zincate.

3. Procédé de placage partiel d'une matière en aluminium, **caractérisé en ce qu'**il comprend le fait de :
réaliser, sur un substrat constitué par la matière en aluminium, un prétraitement de placage partiel grâce au procédé selon la revendication 1 ou 2 ; et
exécuter un traitement de placage sur le substrat.

4. Procédé de placage partiel selon la revendication 3, selon lequel un placage formé en exécutant le traitement de placage est un nickelage.

5. Substrat constitué par une matière en aluminium, le substrat comprenant une réserve pour plaquer ledit substrat, la réserve comprenant une monocouche auto-assemblée formée sur le substrat à partir d'un mélange de nonafluorohexyltriméthoxysilane et de trifluoropropyltriméthoxysilane, un rapport de mélange molaire entre le nonafluorohexyltriméthoxysilane et le trifluoropropyltriméthoxysilane étant de 4 : 6 à 6 : 4.
